# FASCICULE DE BREVET EUROPEEN

(11) **EP 1 187 308 B1**
(45) Date de publication et mention de la délivrance du brevet: **23.06.2004**
(21) Numéro de dépôt: 01402213.1
(22) Date de dépôt: 23.08.2001
(51) Int. Cl.: H03B 5/12

(54) **Oscillateur commande en tension**
Spannungsgesteuerter Oszillator
Voltage controlled oscillator

(43) Date de publication de la demande: 13.03.2002
(73) Titulaire: FRANCE TELECOM, 75015 Paris (FR)
(72) Inventeur: Majos, Jacques, 38420 Le Versoud (FR)
(74) Mandataire: Lemoyne, Didier

(56) Documents cités:
- GB-A- 2 338 849
- US-A- 5 483 207
- PATENT ABSTRACTS OF JAPAN vol. 015, no. 157 (E-1058), 19 avril 1991 (1991-04-19) & JP 03 029504 A (ANRITSU CORP), 7 février 1991 (1991-02-07)
- POLLMAN M D ET AL: "A MMIC RADAR CHIP FOR USE IN AIR-TO-AIR MISSILE FUZING APPLICATIONS" IEEE MTT-S INTERNATIONAL MICROWAVE SYMPOSIUM DIGEST,UI,NEW YORK, IEEE, 17 juin 1996 (1996-06-17), pages 253-256, XP000704895 ISBN: 0-7803-3247-4

## Description

La présente invention concerne un oscillateur commandé en tension, comportant un étage oscillant à deux inverseurs couplés réalisés en technologie CMOS.

L'invention trouve une application particulièrement avantageuse dans le domaine des hautes fréquences, de l'ordre de 5 GHz, utilisées en émission et réception radio.

Il est prévu dans l'avenir le déploiement de réseaux locaux radio permettant de commander un certain nombre d'équipements présents chez un abonné. De manière à limiter le rayonnement afin qu'un réseau local ne puisse pas perturber les réseaux voisins, la bande de fréquence retenue pour l'onde porteuse est celle située autour de 5 GHz. A chaque abonné est attribué un canal d'environ 20 MHz de largeur contenu dans cette bande de fréquence. Il est donc nécessaire de disposer en réception d'un oscillateur local capable d'engendrer des fréquences précises pour sélectionner un canal donné. Cette fonction est réalisée au moyen d'un oscillateur commandé en tension (VCO) apte à produire une fréquence ajustable dans la bande des 5 GHz et avec la largeur de canal requise.

Bien entendu, s'agissant d'applications grand public où le facteur économique est un élément déterminant, il est essentiel d'assurer les performances exigées pour les VCO par des technologies à haut niveau d'intégration et à faible coût de production.

Dans cette perspective, la technologie bipolaire, particulièrement propice à l'intégration des composants RF, pourrait paraître un bon candidat. Cependant, si elle peut être mise en oeuvre avantageusement pour réaliser les fonctions radio des circuits, cette technologie ne peut être utilisée pour le traitement des signaux à plus basse fréquence du fait d'une consommation élevée et d'un coût prohibitif dû aux surfaces de silicium nécessaires. Par contre, la technologie CMOS se prête particulièrement bien aux fonctions de traitement du signal, d'où l'idée de chercher à l'utiliser pour réaliser l'ensemble du circuit, y compris le VCO.

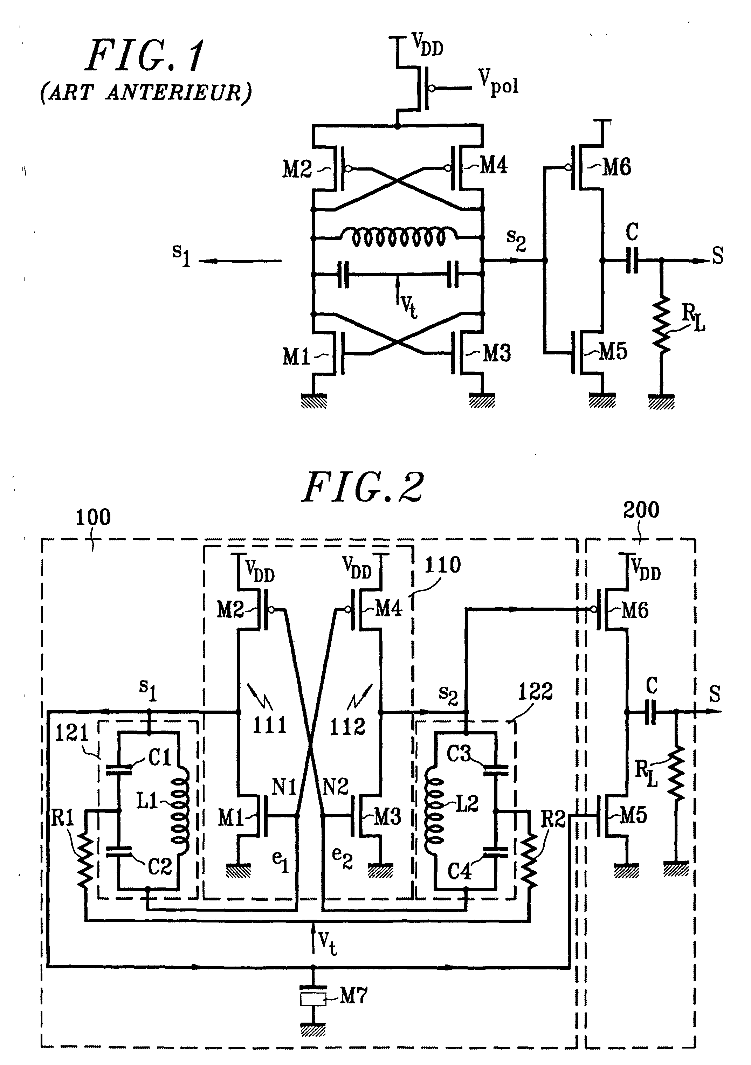

C'est ainsi qu'a été proposé le circuit de la figure 1 qui représente un étage oscillant d'un oscillateur commandé en tension, présentant une structure à deux inverseurs couplés réalisés en technologie CMOS. Plus précisément, les deux inverseurs sont constitués par des transistors de polarité opposée en série, à savoir M1 et M2, d'une part, et M3 et M4, d'autre part. Comme l'indique la figure 1, les deux inverseurs sont en configuration "rebouclée".

La demanderesse a pu établir que le VCO connu de la figure 1 fonctionnant à 5 GHz permettait d'atteindre un bruit de phase de l'ordre de -92 dBc à 100 kHz de la porteuse, ce qui s'avère insuffisant pour certaines applications, comparé à la valeur de -100 dBc obtenue en technologie bipolaire. D'autre part, les sorties S1 et S2 de la structure de la figure 1 sont en opposition de phase et donc mal adaptées à l'utilisation d'un amplificateur de type push-pull pour extraire un signal au-delà de 5 GHz, ceci à cause de la capacité parasite d'entrée de l'amplificateur.

Aussi, le problème technique à résoudre par l'objet de la présente invention est de proposer un oscillateur commandé en tension, comportant un étage oscillant présentant une structure à deux inverseurs couplés réalisés en technologie CMOS, qui permettrait d'obtenir des performances au moins équivalentes à celles des VCO bipolaires, notamment en ce qui concerne le bruit de phase, et qui, subsidiairement, offrirait une meilleure compatibilité avec les amplificateurs de type push-pull que les VCO MOS connus.

La solution au problème technique posé consiste, selon la présente invention, en ce que lesdits inverseurs sont câblés pour former un quadripôle à deux entrées et deux sorties, correspondant respectivement aux entrées et aux sorties des inverseurs, le gain du quadripôle étant maximal sur chacune des sorties quand les entrées sont en phase, et en ce que deux circuits oscillants sont disposés en parallèle respectivement entre les entrées et les sorties des inverseurs, lesdits circuits oscillants étant commandés en fréquence par une tension d'accord.

Ainsi, du fait du câblage conférant un gain maximal au quadripôle pour des entrées en phase, l'oscillateur selon l'invention fonctionne automatiquement sur la fréquence assurant cette condition, d'où une meilleure stabilité d'oscillation et un bruit de phase plus faible résultant de l'auto-synchronisation des deux inverseurs.

Selon un mode de réalisation particulier de l'oscillateur commandé en fréquence, objet de l'invention, chaque inverseur est constitué de deux transistors MOS de polarité opposée disposés en série, l'entrée de l'inverseur étant située sur la grille d'un transistor d'une première polarité et la sortie au point milieu des deux transistors.

Une première variante de l'invention prévoit que l'entrée d'un inverseur est reliée à la grille du transistor d'une deuxième polarité de l'autre inverseur, la deuxième polarité étant opposée à ladite deuxième polarité. Comme on le verra en détail plus loin, l'avantage de cette première variante est que les deux sorties de l'étage oscillant sont en phase. Il est alors permis d'envisager que l'oscillateur conforme à l'invention comporte un étage amplificateur constitué de deux transistors MOS de polarité opposée disposés en série, chaque sortie dudit étage oscillant étant reliée à la grille d'un desdits transistors MOS. Ainsi, la capacité parasite de l'amplificateur, de type push-pull, vue par chacune des sorties est la moitié de la capacité parasite totale. Il en résulte une meilleure bande passante et la possibilité d'augmenter la fréquence de l'oscillateur au-delà de 5 GHz.

Une deuxième variante de l'invention prévoit que la sortie d'un inverseur est reliée à la grille du transistor d'une deuxième polarité de l'autre inverseur, la deuxième polarité étant opposée à ladite première polarité. Selon cette deuxième variante, ces deux sorties de l'étage oscillant sont en opposition de phase, il n'est donc pas possible d'obtenir l'avantage de la première variante d'augmentation de la bande passante de l'oscillateur avec un étage amplificateur de type push-pull. Toutefois, cet avantage peut néanmoins être atteint si, selon l'invention, l'oscillateur comporte un étage amplificateur constitué de deux transistors MOS de même polarité disposés en série, chaque sortie dudit étage oscillant étant reliée à la grille d'un desdits transistors MOS.

La description qui va suivre en regard des dessins annexés, donnés à titre d'exemples non limitatifs, fera bien comprendre en quoi consiste l'invention et comment elle peut être réalisée.
La figure 2 est un schéma d'une première réalisation d'un oscillateur commandé en tension, conforme à l'invention.
La figure 3 est un schéma d'une deuxième réalisation d'un oscillateur commandé en tension, conforme à l'invention.
La figure 4 est un schéma d'un circuit de commande des circuits oscillants des oscillateurs des figures 2 et 3.

Sur la figure 2 est représenté un oscillateur commandé en tension, comportant un étage oscillant 100 et un étage amplificateur 200.

L'étage oscillant 100 présente une structure à deux inverseurs 111, 112 couplés réalisés en technologie CMOS. Plus précisément, un premier inverseur 111 est constitué par les deux transistors MOS M1, M2, de polarité opposée, disposés en série, l'entrée e1 dudit inverseur 111 étant située sur la grille du transistor M1, ici d'une première polarité N, et la sortie s1 étant prise au point milieu des deux transistors MOS M1, M2. Symétriquement, le deuxième inverseur 112 comprend les deux transistors MOS M3, M4, également de polarité opposée et disposés en série, l'entrée e2 et la sortie s2 de cet inverseur étant respectivement située sur la grille du transistor M3, de polarité N, et sur le point milieu des deux transistors M3, M4.

Dans l'exemple de réalisation de la figure 1, le couplage des deux inverseurs 111, 112 est effectué en reliant l'entrée e1, e2 d'un inverseur à la grille du transistor MOS M4, M2, de deuxième polarité P opposée à la première, de l'autre inverseur.

Il est à noter une particularité du montage des deux inverseurs 111, 112 de la figure 1 qui réside dans le fait que du point de vue câblage les deux inverseurs ne sont pas fermés puisque les grilles des transistors M1 et M2, d'une part, et M3 et M4, d'autre part, ne sont pas interconnectées à un même noeud. Cependant, le quadripôle 110, dont les entrées et les sorties correspondent aux entrées e1, e2 et aux sorties s1, s2 des inverseurs, présentent un gain maximal quand les entrées e1, e2 sont en phase. En d'autres termes, lorsque le quadripôle 110 a atteint son point de fonctionnement nominal défini par le gain maximum, les noeuds N1 et N2 sont en phase et, de ce fait, les inverseurs 111, 112 sont fonctionnellement fermés.

Pour compléter l'étage oscillant 100, deux circuits oscillants 121, 122 sont disposés en parallèle respectivement entre les entrées e1, e2 et les sorties s1, s2 des inverseurs 111, 112. Comme l'indique la figure 2, les circuits oscillants 121, 122 sont commandés en fréquence par une tension Vt d'accord à travers les résistances R1 et R2. Chaque circuit oscillant est formé d'une inductance L1, L2 et d'une capacité en parallèle réalisée par deux capacités C1, C2 et C3, C4 montées en série ; ce sont en fait des transistors MOS de type N ou P (varactors).

L'étage 200 de sortie est un amplificateur de type push-pull constitué de deux transistors MOS M5, M6 de polarité opposée disposés en série, commandés sur leur grille respective par les signaux des sorties s1, s2 de l'étage oscillant 100, cette double commande du push-pull 200 n'étant possible que parce que les sorties s1, s2 sont en phase. Ainsi, chaque signal de sortie ne charge qu'un seul des transistors M5, M6, ce qui confère à l'oscillateur de l'invention une meilleure bande passante par rapport au VCO connu de l'art antérieur (figure 1) où les sorties s1, s2 sont en opposition de phase et où une même sortie, s2, charge simultanément les deux transistors du push-pull.

On observera sur la figure 1 que la sortie s1 est en fait chargée par deux transistors, à savoir le transistor M5 de l'étage amplificateur 200 et un transistor M7 de type N afin d'équilibrer les charges des sorties s1 et s2. En effet, la sortie s2 est chargée par le transistor M6 de type P de l'amplificateur 200 qui est plus large que le transistor M5 de type N dans les rapports des mobilités des électrons et des trous. Cet équilibrage permet d'éviter d'apporter des distorsions au signal S de sortie.

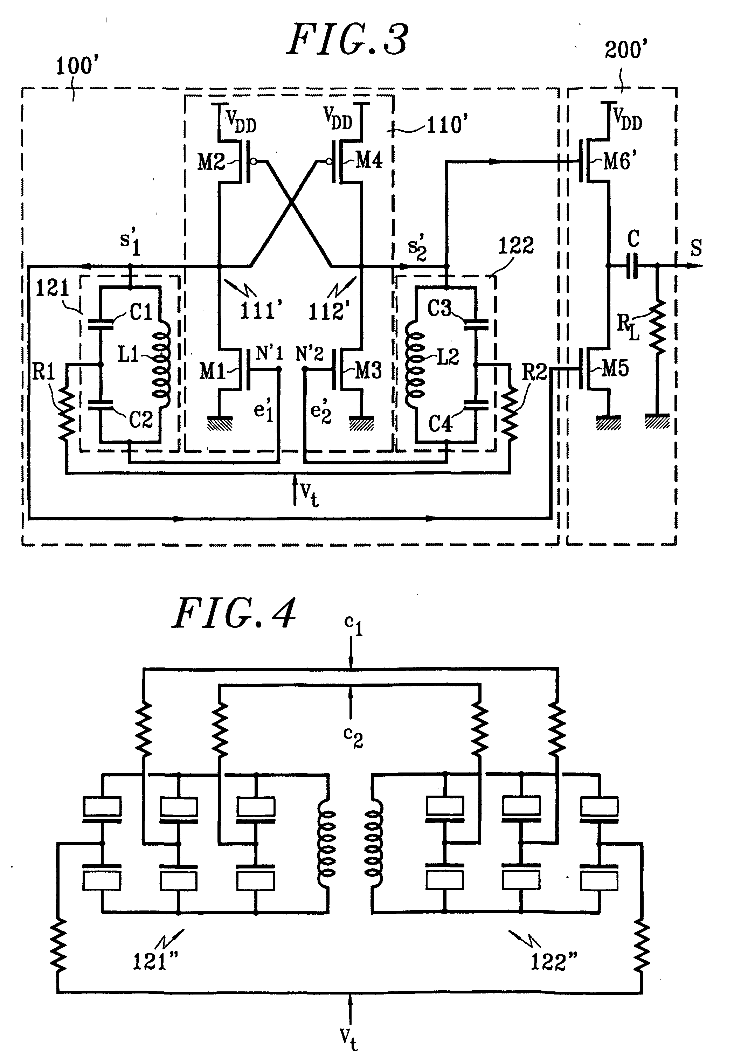

La figure 3 montre un deuxième exemple de réalisation d'un oscillateur commandé en tension, objet de l'invention, qui diffère de l'exemple de la figure 2 par la façon dont sont couplés les inverseurs 111' et 112'. Dans l'étage oscillant 100' de la figure 3, la sortie s1', s2' d'un inverseur 111', 112' est reliée à la grille du transistor MOS M4, M2 de polarité P opposée à celle des transistors MOS M1, M3, de l'autre inverseur.

Le quadripôle 110' présente également un gain maximal quand les entrées e'1, e'2 des inverseurs 111', 112' sont en phase. Par contre, les sorties s'1 et s'2 sont en opposition de phase, ce qui exclut de pouvoir les appliquer sur les transistors MOS M5, M6 de l'étage amplificateur 200, comme sur la figure 2. Une solution permettant d'augmenter la bande passante de l'oscillateur de la figure 3 consiste à réaliser un étage amplificateur 200' avec deux transistors MOS M5, M6' de même polarité placés en série, chaque sortie s'1, s'2 de l'étage oscillant 100' étant reliée à la grille d'un desdits transistors M5, M6'.

Afin de faciliter l'ajustage de la bande de fréquence, on peut au réglage fin assuré par la tension Vt d'accord ajouter un réglage grossier obtenu grâce à un signal de commande analogique ou logique. Pour cela, et ainsi que le la figure 4, on ajoute en parallèle dans les circuits oscillants 121", montre la figure 4, on ajoute en parallèle dans les circuits oscillants 121 ", 122" un ou plusieurs ensembles de condensateurs MOS pilotés par un signal de commande. Dans l'exemple représenté sur la figure 4, deux ensembles de condensateurs MOS sont pilotés par deux signaux c1, c2 de commande numérique codés sur 2 bits, ce qui donne 4 positions de réglage grossier.

## Revendications

1. Oscillateur commandé en tension, comportant un étage oscillant (100 ; 100') présentant une structure à deux inverseurs (111, 112 ; 111', 112') couplés réalisés en technologie CMOS, **caractérisé en ce que** lesdits inverseurs sont câblés pour former un quadripôle (110 ; 110') à deux entrées (e1, e2 ; e'1, e'2) et deux sorties (s1, s2 ; s'1, s'2), correspondant respectivement aux entrées et aux sorties des inverseurs, le gain du quadripôle (110 ; 110') étant maximal sur chacune des sorties quand les entrées sont en phase, et **en ce que** deux circuits oscillants (121, 122) sont disposés en parallèle respectivement entre les entrées (e1, e2 ; e'1, e'2) et les sorties (s1, s2 ; s'1, s'2) des inverseurs, lesdits circuits oscillants (121, 122) étant commandés en fréquence par une tension (Vt) d'accord.

2. Oscillateur selon la revendication 1, **caractérisé en ce que** chaque inverseur (111, 112 ; 111', 112') est constitué de deux transistors MOS (M1, M2, M3, M4) de polarité opposée disposés en série, l'entrée (e1, e2 ; e'1, e'2) de l'inverseur étant située sur la grille d'un transistor (M1, M3) d'une première polarité et la sortie au point milieu des deux transistors.

3. Oscillateur selon la revendication 2, **caractérisé en ce que** l'entrée (e1, e2) d'un inverseur (111, 112) est reliée à la grille du transistor (M4, M2) d'une deuxième polarité de l'autre inverseur, la deuxième polarité étant opposée à ladite première polarité.

4. Oscillateur selon la revendication 2, **caractérisé en ce que** la sortie (s'1, s'2) d'un inverseur (111', 112') est reliée à la grille du transistor (M4, M2) d'une deuxième polarité de l'autre inverseur, la deuxième polarité étant opposée à ladite première polarité.

5. Oscillateur selon la revendication 3, **caractérisé en ce qu'**il comporte un étage amplificateur (200) constitué de deux transistors MOS (M5, M6) de polarité opposée disposés en série, chaque sortie (s1, s2) dudit étage oscillant (100) étant reliée à la grille d'un desdits transistors MOS (M5, M6).

6. Oscillateur selon la revendication 4, **caractérisé en ce qu'**il comporte un étage amplificateur (200') constitué de deux transistors MOS (M5 M6') de même polarité disposés en série, chaque sortie (s'1, s'2) dudit étage oscillant (100') étant reliée à la grille d'un desdits transistors MOS (M5, M6').

## Claims

1. A voltage-controlled oscillator which includes an oscillating stage (100; 100') in the form of a coupled double-inverter structure (111, 112; 111', 112') in CMOS technology, **characterised in that** said inverters are wired to form a four-pole circuit (110; 110') with two inputs (e1, e2; e'1, e'2) and two outputs (s1, s2; s'1, s'2), respectively corresponding to the inputs and outputs of the inverters, the gain of this four-pole circuit (110; 110') being maximum at each of the outputs when the inputs are in phase, and **in that** the two oscillating circuits (121, 122) are arranged respectively in parallel between the inputs (e1, e2; e'1, e'2) and the outputs (s1, s2; s'1, s'2) of the inverters, said oscillating circuits (121, 122) being frequency-controlled by means of a tuning voltage (Vt).

2. An oscillator according to claim 1, **characterised in that** each inverter (111, 112; 111', 112') is composed of two MOS transistors (M1, M2, M3, M4) of opposite polarity arranged in series, the input (e1, e2; e'1, e'2) of an inverter being located on the gate of a transistor (M1, M3) of a first polarity, and the output at the centre point of the two transistors.

3. An oscillator according to claim 2, **characterised in that** the input (e1, e2) of one inverter (111, 112) is connected to the gate of the transistor (M4, M2) of a second polarity of the other inverter, the second polarity being opposite to said first polarity.

4. An oscillator according to claim 2, **characterised in that** the output (s'1, s'2) of one inverter (111', 112') is connected to the gate of the transistor (M4, M2) of a second polarity of the other inverter, the second polarity being opposite to said first polarity.

5. An oscillator according to claim 3, **characterised in that** it includes an amplifier stage (200) composed of two MOS transistors (M5, M6) of opposite polarity connected in series, each output (s1, s2) of said oscillating stage (100) being connected to the gate of said MOS transistors (M5, M6).

6. An oscillator according to claim 4, **characterised in that** it includes an amplifier stage (200') composed of two MOS transistors (M5, M6') of the same polarity connected in series, each output (s'1, s'2) of said oscillating stage (100) being connected to the gate of said MOS transistors (M5, M6').

## Patentansprüche

1. In Spannung gesteuerter Oszillator mit einer eine Struktur mit zwei gekoppelten, in CMOS-Technologie realisierten Stromwendern (111, 112; 111', 112') aufweisenden oszillierenden Stufe (100; 100'), **dadurch gekennzeichnet, dass** die genannten Stromwender zur Bildung eines Quadrupols (110; 110') mit zwei Eingängen (e1, e2; e'1; e'2) und zwei Ausgängen (s1, s2; s'1, s'2) verkabelt sind, die jeweils den Eingängen und Ausgängen der Stromwender entsprechen, wobei die Verstärkung des Quadrupols (110; 110') auf jedem der Ausgänge maximal ist, wenn die Eingänge gleichphasig sind, und dass zwei Schwingkreise (121, 122) parallel jeweils zwischen den Eingängen (e1, e2; e'1; e'2) und den Ausgängen (s1, s2; s'1, s'2) der Stromwender angeordnet sind, wobei die genannten Schwingkreise (121, 122) in Frequenz durch eine Abstimmungsspannung (Vt) gesteuert sind.

2. Oszillator gemäß Anspruch 1, **dadurch gekennzeichnet, dass** jeder Stromwender (111, 112; 111', 112') aus zwei in Serie angeordneten Transistoren MOS (M1, M2, M3, M4) mit entgegengesetzter Polarität gebildet werden, wobei der Eingang (e1, e2; e'1, e'2) des Stromwenders sich auf dem Gitter eines Transistors (M1, M3) einer ersten Polarität und der Ausgang am Mittelpunkt der beiden Transistoren befinden.

3. Oszillator gemäß Anspruch 2, **dadurch gekennzeichnet, dass** der Eingang (e1, e2) eines Stromwenders (111, 112) an das Gitter des Transistors (M4, M2) einer zweiten Polarität des anderen Stromwenders angeschlossen ist, wobei die zweite Polarität der genannten ersten Polarität entgegengesetzt ist.

4. Oszillator gemäß Anspruch 2, **dadurch gekennzeichnet, dass** der Ausgang (s'1, s'2) eines Stromwenders (111', 112') an das Gitter des Transistors (M4, M2) einer zweiten Polarität des anderen Stromwenders angeschlossen ist, wobei die zweite Polarität der genannten ersten Polarität entgegengesetzt ist.

5. Oszillator gemäß Anspruch 3, **dadurch gekennzeichnet, dass** er eine aus zwei in Serie angeordneten Transistoren MOS (M5, M6) mit entgegengesetzter Polarität gebildete Verstärkerstufe (200) umfasst, wobei jeder Ausgang (s1, s2) der genannten oszillierenden Stufe (100) an das Gitter einer der genannten Transistoren MOS (M5, M6) angeschlossen ist.

6. Oszillator gemäß Anspruch 4, **dadurch gekennzeichnet, dass** er eine aus zwei Transistoren MOS (M5 M6') derselben Polarität, in Serie angeordnete gebildete Verstärkerstufe (200') umfasst, wobei jeder Ausgang (s'1, s'2) der genannten oszillierenden Stufe (100') an das Gitter einer der genannten Transistoren MOS (M5, M6') angeschlossen ist.
